# FASCICULE DE BREVET EUROPEEN

(11) **EP 1 639 157 B1**
(45) Date de publication et mention de la délivrance du brevet: **28.03.2007**
(21) Numéro de dépôt: 04767480.9
(22) Date de dépôt: 25.06.2004
(51) Int. Cl.: C30B 1/02, C30B 29/06, C30B 25/02, H01L 21/00, B82B 3/00

(54) **PROCEDE DE SYNTHESE D'UN MATERIAU CRISTALLIN ET MATERIAU OBTENU PAR CE PROCEDE**
VERFAHREN ZUR SYNTHESE EINES KRISTALLINEN MATERIALS UND DANACH ERHALTENES MATERIAL
METHOD OF SYNTHESISING A CRYSTALLINE MATERIAL AND MATERIAL THUS OBTAINED

(30) Priorité: 27.06.2003 FR 0307849
(43) Date de publication de la demande: 29.03.2006
(73) Titulaire: CENTRE NATIONAL DE LA RECHERCHE SCIENTIFIQUE (CNRS), 75794 Paris Cedex 16 (FR)
(72) Inventeur: PRIBAT, Didier, F-92310 Sevres (FR)
(74) Mandataire: Warcoin, Jacques
(86) Numéro de dépôt international: PCT/FR2004/001634
(87) Numéro de publication internationale: WO 2005/001168

(56) Documents cités:
- FR-A- 2 832 995
- US-A- 5 827 773
- KUNII ET AL.: "Solid Phase lateral epitaxy of chemical vapor deposited amorphous silicon by furnace annealing" JOURNAL OF APPLIED PHYSICS, vol. 54, no. 5, mai 1983 (1983-05), pages 2847-2849, XP002274241 NEW YORK US cité dans la demande
- AUDIER ET AL.: "Crystallographic orientations of catalytic particles in filamentous carbon; case of simple conical particles" JOURNAL OF CRYSTAL GROWTH., vol. 55, 1981, pages 549-556, XP002274242 NORTH-HOLLAND PUBLISHING CO. AMSTERDAM., NL ISSN: 0022-0248 cité dans la demande
- MEYYAPAN ET AL.: "Carbon nanotube growth by PECVD: a review" PLASMA SOURCES AND TECHNOLOGY, vol. 12, 2003, pages 205-216, XP002274243 UK cité dans la demande

## Description

L'invention concerne un-procédé de synthèse d'un matériau cristallin et le matériau obtenu par ce procédé.

Plus particulièrement, l'invention concerne un procédé de synthèse d'un matériau cristallin, comportant les étapes de :
a) réalisation, sur un substrat constitué d'un premier matériau, de germes d'un catalyseur adapté pour solubiliser du carbone,
b) croissance de nanotubes de carbone à partir des germes, et
c) réalisation d'une couche d'un deuxième matériau, comportant au moins un domaine monocristallin orienté à partir d'un germe.

Le procédé selon l'invention permet notamment de réaliser une couche de silicium au moins partiellement cristallisé, tel que du silicium polycristallin, sur un substrat amorphe tel que du verre. Dans ce cas notamment, le produit obtenu par le procédé selon l'invention est particulièrement intéressant pour des applications électroniques telles que la fabrication d'écrans plats.

Afin d'optimiser l'orientation des domaines monocristallins les uns par rapport aux autres, au cours de l'étape b), on oriente les germes sous champ magnétique.

Le procédé selon l'invention peut comporter en outre, l'une et/ou l'autre des dispositions suivantes :
- le premier matériau est un matériau amorphe ;
- le catalyseur comprend un métal de transition ;
- le deuxième matériau est du silicium;
- l'étape c) comporte les sous étapes:
   - c1) au cours de laquelle on dépose, sur le substrat et des germes situés au sommet de nanotubes de carbone, le deuxième matériau sous forme amorphe, puis
   - c2) au cours de laquelle on procède à une cristallisation du deuxième matériau en phase solide;
- l'étape a) comporte les sous étapes :
   - a1) au cours de laquelle on réalise, sur le substrat, des plots du catalyseur, puis
   - a2) au cours de laquelle on recuit le substrat et les plots, pour former des germes ;
- l'étape a) comporte les sous étapes :
   - a'1) au cours de laquelle on dépose, sur le substrat, un film mince constitué du catalyseur, puis
   - a'2) au cours de laquelle on recuit le substrat et le film mince, pour former des germes;
- l'étape a) comporte les sous étapes:
   - a"1) au cours de laquelle on implante des ions métalliques dans une couche mince,
   - a"2) au cours de laquelle on réalise un recuit de la couche mince dans laquelle des ions ont été implantés, afin de former des précipités métalliques à partir des ions implantés,
   - a"3) au cours de laquelle on procède à une attaque sélective de la couche mince pour faire apparaître en surface des précipités métalliques qui formeront des germes; et
- un champ magnétique est appliqué, au cours des étapes a2), a'2) ou a"2), pour orienter les germes;
- l'étape a) comporte les sous étapes:
   - a'''1) de dépôt d'une couche de résine de masquage sur la couche mince, de réalisation de motifs dans la, résine, et de gravure de la couche mince, au niveau des motifs pour former des puits,
   - a"'2) de dépôt du deuxième matériau,
   - a"'3) de dissolution de la résine, et
   - a"'4) de recuit de la couche mince et du deuxième matériau dans les puits, pour former des germes.

Selon un autre aspect, l'invention concerne un matériau comportant :
- un substrat constitué d'un premier matériau, s'étendant essentiellement dans un plan,
- des nanotubes de carbone s'étendant longitudinalement essentiellement perpendiculairement au plan du substrat, entre une extrémité libre et un extrémité solidaire du substrat,
- des germes d'un catalyseur sensiblement situés à proximité de l'extrémité libre des nanotubes de carbone et
- au moins un domaine d'un deuxième matériau cristallisé et orienté à partir d'un moins un germe.

Les caractéristiques ci-dessus ainsi que d'autres apparaîtront mieux à la lecture de la description qui suit de deux modes particuliers d'exécution de l'invention, donnés à titre d'exemple non limitatif.

La description se réfère aux dessins qui l'accompagnent, dans lesquels:
- la figure 1 représente schématiquement un premier exemple de mode de mise en oeuvre du procédé selon l'invention ;
- la figure 2 est une photographie prise en microscopie électronique à balayage d'un substrat sur lequel ont été réalisés des germes, conformément aux premières étapes du procédé de la figure 1 ;
- la figure 3 représente schématiquement en coupe le début de la croissance de nanotubes de carbone à partir des germes tels que ceux représentés sur la figure 2 ;
- la figure 4 est une photographie réalisée par microscopie électronique en transmission de l'extrémité libre d'un nanotube de carbone et du germe ayant assisté sa croissance ;
- la figure 5 est une photographie en microscopie électronique à balayage d'un ensemble de nanotubes de carbone dont la croissance a été réalisée selon les premières étapes du procédé de la figure 1;
- la figure 6 illustre schématiquement sur un substrat vu en coupe, la cristallisation d'une couche mince de silicium amorphe, conformément au procédé illustré par la figure 1 ;
- la figure 7 représente schématiquement certaines étapes d'un deuxième exemple de mode de mise en oeuvre du procédé selon l'invention ;
- la figure 8 représente schématiquement certaines étapes d'un troisième exemple de mode de mise en oeuvre du procédé selon l'invention.

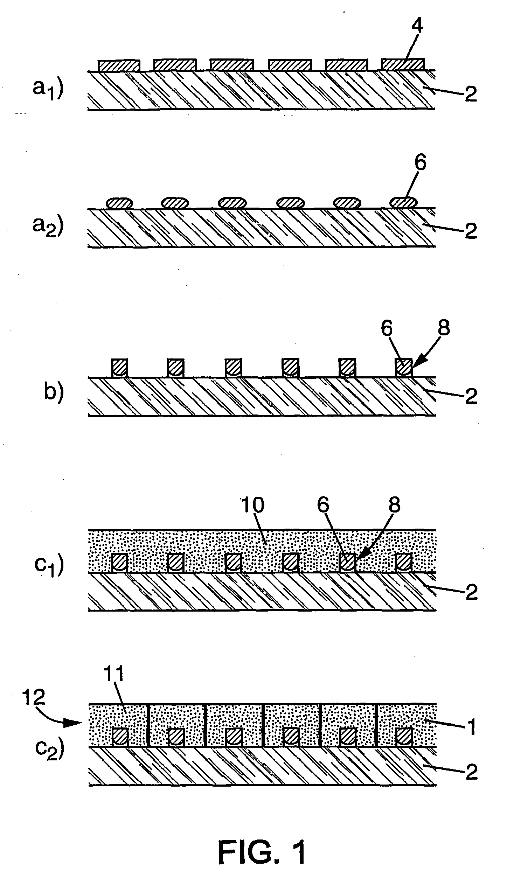

Un premier exemple, non limitatif, de mode de mise en oeuvre du procédé selon l'invention, est décrit ci-dessous en relation avec les figures 1 à 6.

Selon cet exemple, le procédé selon l'invention est appliqué à la réalisation, sur un substrat 2 d'un premier matériau, ici de verre, d'une couche d'un deuxième matériau, ici de silicium polycristallin 1 (voir figure 1 c2)).

Selon cet exemple, le procédé comporte:
- une étape a1) au cours de laquelle on réalise, sur un substrat 2, des plots 4,
- une étape a2) au cours de laquelle on recuit le substrat 2 et les plots 4 pour former des germes 6,
- une étape b) de croissance de nanotubes de carbone 8 à partir des germes 6,
- une étape c1) au cours de laquelle on dépose sur l'ensemble du substrat 2, des germes 6 et des nanotubes de carbone 8, une couche de silicium amorphe 10, et
- une étape c2) au cours de laquelle on recuit le substrat 2 sur lequel est déposée la couche de silicium amorphe 10, afin de cristalliser, en phase solide, le silicium et obtenir des grains 11 de silicium orientés.

Les plots 4 sont constitués d'un catalyseur, ici un métal, typiquement un métal de transition, qui sert à catalyser la croissance des nanotubes de carbone 8. Il peut s'agir de fer, de cobalt, de nickel, de platine, etc.

Pour former les plots 4, on dépose sur le substrat 2, au cours de l'étape a1, une couche mince, par exemple, de fer, que l'on grave ensuite par des procédés classiques de lithographie, pour former un réseau de plots 4. Ces plots sont typiquement espacés de 2 à 3 microns.

Au cours de l'étape a2), on recuit la couche mince de fer vers 650-750°C, sous atmosphère réductrice.

Selon une variante, on dépose sur le substrat 2, une couche mince de 10 nanomètres d'épaisseur, du catalyseur, puis on réalise un recuit de l'ensemble.

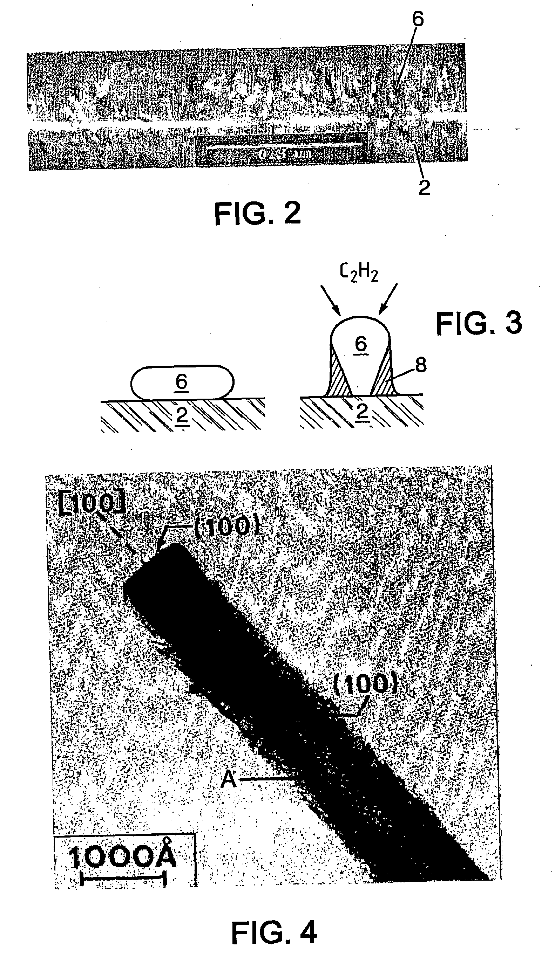

La figure 2 illustre cette variante par laquelle des germes 6 ont été formés à partir d'une couche mince de nickel recuite à 700°C. On simplifie ainsi la façon d'obtenir les germes 6. En effet, il n'est pas nécessaire de disposer d'un réseau régulier bien ordonné. Il suffit qu'en moyenne, les germes 6 soient distants de 3 à 6 microns (Y. Kunii, M. Tabe and K. Kajiyama, J. Appl. Phys., vol. 54, p.2847 (1983)), de manière à éviter la nucléation homogène, dans le silicium amorphe, entre deux germes 6, au cours de l'étape de cristallisation c2). En effet, la nucléation homogène se fait de manière aléatoire et les grains 11 ainsi générés rompraient l'organisation de la couche de silicium après cristallisation.

Au cours de l'étape b) la croissance des nanotubes de carbone 8 à partir des germes 6 est effectuée par dépôt chimique en phase vapeur (CVD) purement thermique vers 850-1000°C ou par dépôt chimique en phase vapeur assisté par plasma (PECVD), vers 600-700°C. Pour cette méthode de croissance, on se réfèrera par exemple à l'article de M. Meyyappan et Coll., Plasma Sources Sci. Technol., No. 12, page 205 (2003).

Comme représenté sur la figure 3, au cours de cette étape de croissance, les espèces comportant du carbone, ici C₂H₂, de la phase gazeuse, sont décomposées sur les germes 6. Le carbone libéré est dissous par le germe 6 et précipite sur ses flancs, en général plus froids, en donnant naissance à un nanotube 8. La forme du germe 6 évolue et se déplace au niveau de l'extrémité libre du nanotube 8, dans le cas où il interagit peu avec le substrat 2, c'est-à-dire lorsque γa+γ* ≥ yb, où γa, γb et γ* sont respectivement les énergies superficielles du catalyseur, du substrat 2 et de l'interface catalyseur/substrat 2.

Dans ce cas, après croissance, l'orientation du germe 2 par rapport à l'axe du nanotube de carbone 8 n'est pas quelconque (voir M. Audier et Coll., J. Cryst. Growth., No. 55, page 549 (1981)).

En particulier, comme représenté sur la figure 4 pour des germes 6 de fer, on constate que l'axe [100] du germe 6 est parallèle à l'axe A du nanotube de carbone 8. L'orientation peut être différente pour d'autres métaux de transition mais dans tous-les cas il existe une corrélation précise entre l'orientation du germe 6 et l'axe du nanotube de carbone 8 après croissance. La croissance des nanotubes de carbone 8 transforme un germe 6 d'orientation aléatoire en un germe 6 d'orientation précise par rapport à l'axe du nanotube de carbone 8.

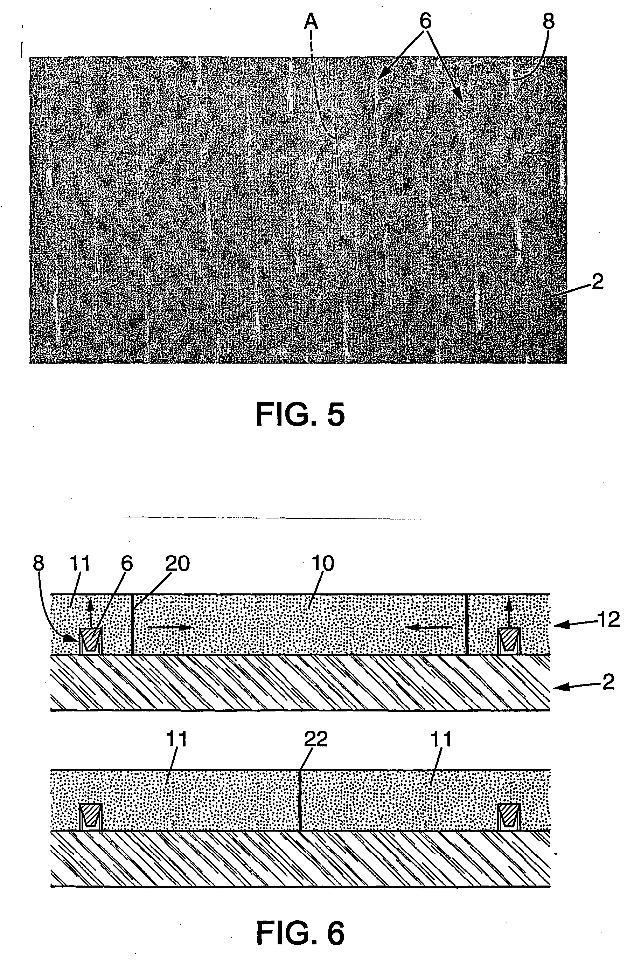

Comme représenté sur la figure 5, si les nanotubes de carbone 8, obtenus par PECVD, sont tous parallèles et verticaux, et si d'autre part, les germes 6 ont leur axe [100] parallèle à l'axe A des nanotubes de carbone 8, tous les germes 6, après croissance des nanotubes de carbone 8, ont le même axe de zone. La croissance des nanotubes de carbone 8 selon le procédé selon l'invention, transforme donc une couche de catalyseur d'orientation totalement aléatoire en un réseau de germes 6, au sommet des nanotubes de carbone 8, de même axe de zone.

Afin de parfaire l'orientation des germes métalliques dans le plan du substrat 2, un champ magnétique judicieusement orienté dans le plan du substrat 2 pet être appliqué pendant l'étape a2 de formation des germes 6 ou pendant l'étape b) de croissance des nanotubes de carbone 8 à partir des germes 6.

Au cours de l'étape c1) on dépose une couche mince de silicium amorphe 10 sur le réseau des nanotubes de carbone 8 au sommet desquels les germes 6 sont orientés. Cette étape c1) est effectuée dans des conditions connues de l'homme de l'art, par PECVD ou LPCVD (Low Pressure Chemical Vapor Deposition, soit dépôt chimique en phase vapeur à basse pression), par décomposition de SiH₄ ou Si₂H₆, à une température comprise entre 200 et 600°C.

Au cours de l'étape c2), la couche de silicium amorphe 10 est cristallisée en phase solide, dans un four à atmosphère contrôlée, à une température comprise typiquement entre 450 et 550°C. On obtient alors une couche de silicium polycristallin très fortement texturée et d'orientation superficielle correspondant à l'orientation des germes 6 au sommet des nanotubes de carbone 8. Il y a épitaxie en phase solide du silicium sur les germes 6. Comme l'orientation de ces germes 6 est la même, on obtient *in fine* une couche mince de silicium polycristallin 12 très texturée, voire monocristalline sur un substrat 2 amorphe.

La croissance et l'épitaxie en phase solide du silicium sur les germes 6 sont représentées sur la figure 6. Dans une première phase de la croissance, le front de cristallisation se propage, à partir du sommet des germes 6, dans l'épaisseur de la couche 10. Puis, lorsque toute l'épaisseur de la couche 10 est cristallisée, le front de cristallisation 20 se déplace parallèlement au plan de la couche 10. Le silicium épitaxié sur les germes 6, et donc orienté sur ceux-ci, cristallise à partir de chacun des germes 6. Le front de cristallisation 20 se déplace latéralement jusqu'à obtenir un joint de grain à faible désorientation 22.

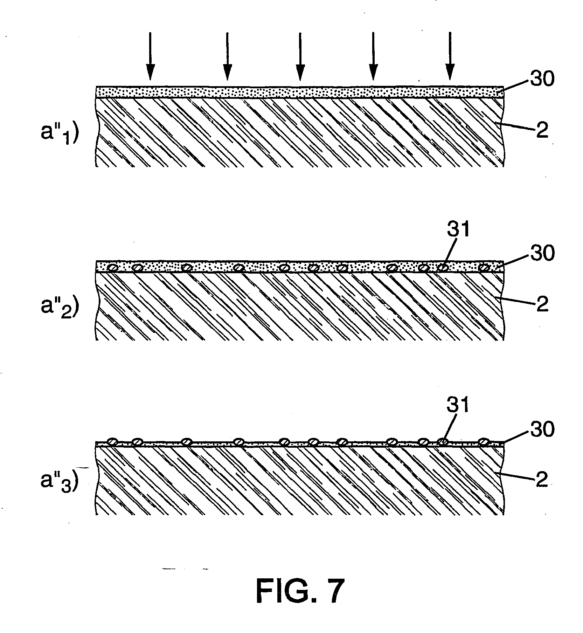

Un deuxième exemple, également non limitatif, de mode de mise en oeuvre du procédé selon l'invention, est décrit ci-dessous en relation avec la figure 7. Selon cet exemple, le mode de mise en oeuvre du procédé selon l'invention diffère de celui exposé ci-dessus essentiellement au niveau des étapes de formation des germes 6.

Comme représenté sur la figure 7, on réalise une couche mince 30 d'un matériau diélectrique connu de l'homme de l'art, sur un substrat 2 amorphe. Le matériau diélectrique peut être, par exemple, de la silice (SiO₂) ou du nitrure de silicium (Si₃N₄).

Au cours d'une étape a"1), on implante des ions métalliques dans la couche mince 30. Les ions métalliques correspondent au catalyseur choisi pour former des germes 6.

Au cours d'une étape a"2), on effectue un recuit, vers 600°C, du substrat 2 et de la couche mince 30 ayant subi l'implantation ionique. Au cours de ce recuit, les atomes métalliques précipitent. L'espace et la taille des précipités 31 peuvent être ajustés en fonction de la dose d'implantation au cours de l'étape a"1). Typiquement, on utilisera des doses de l'ordre de 10¹⁷ à 10¹⁸ ions par cm².

Au cours d'une étape a"3), on procède à une attaque chimique de la couche mince 30 de diélectrique pour "déchausser" les précipités métalliques 31. La partie émergente des précipités métalliques 31 constitue les germes 6 à partir desquels on peut procéder à la croissance d'un nanotube de carbone 8, puis au dépôt de silicium amorphe et à sa cristallisation, conformément aux étapes b), c1) et c2) du premier exemple de mise en oeuvre du procédé selon l'invention exposé ci-dessus.

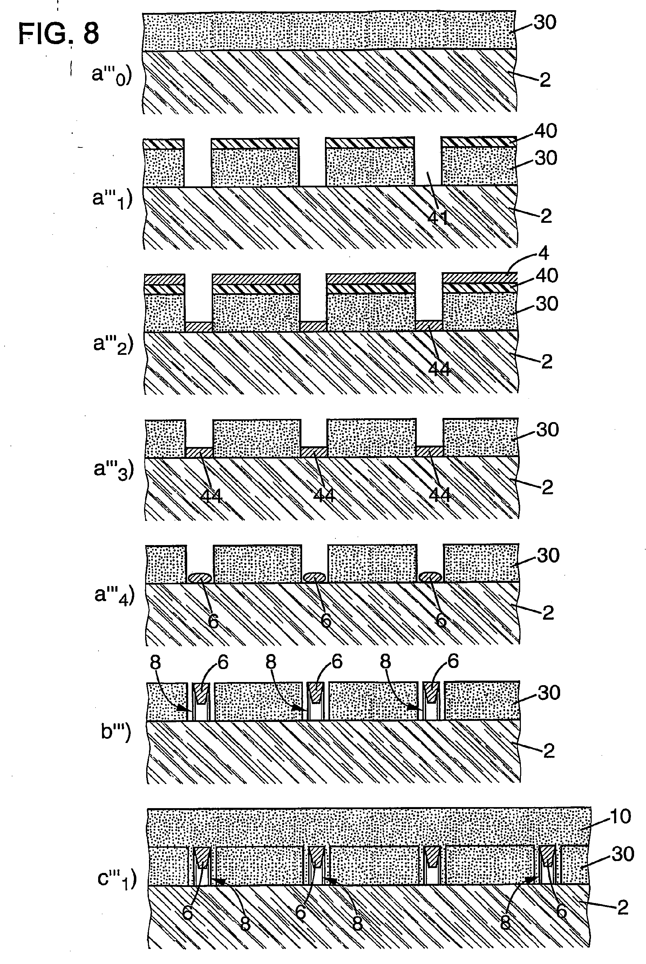

Un troisième exemple, également non limitatif, de mode de mise en oeuvre du procédé selon l'invention, est décrit ci-dessous en relation avec la figure 8. Selon cet exemple, le mode de mise en oeuvre du procédé selon l'invention diffère de ceux exposés ci-dessus essentiellement au niveau des étapes de formation des germes 6.

Comme représenté sur la figure 8, on réalise par une étape a"'0), une couche mince 30 d'un matériau diélectrique connu de l'homme de l'art, sur un substrat 2 amorphe. Le matériau diélectrique peut être, par exemple, de la silice (SiO₂) ou du nitrure de silicium (Si₃N₄).

Au cours d'une étape a'''1) :
- on dépose une couche de résine 40 de masquage sur la couche mince 30,
- on réalise, par exemple par photolithographie, des motifs dans la résine 40, de manière à ce que la résine 40 masque la couche mince 30, sauf sur certaines zones au niveau desquelles la couche mince 30 est à nu, et
- on grave la couche mince 30, jusqu'au substrat 2, au niveau des zones laisées à nu, pour former des puits 41.

Au cours d'une étape a"'2), on dépose un métal catalyseur 44 choisi pour former des germes 6.

Au cours d'une étape a'''3), on dissout la résine 40. Le catalyseur 44 présent sur la résine est donc également éliminé au cours de cette opération.

Au cours d'une étape a"'4), on effectue un recuit, vers 600°C, du substrat 2, de la couche mince 30 et du catalyseur 44 présent au fond des puits 41. Au cours de ce recuit, le catalyseur forme des germes 6 sous forme de nanoparticules.

On procède ensuite à une étape b''' de croissance de nanotubes de carbone 8, à partir des germes 6, de manière analogue à l'étape b) décrite ci-dessus, de manière à orienter les germes 6.

Enfin, on procède à une étape c'''1) de dépôt d'une couche de silicium amorphe 10, puis à une étape c'''2) (non représentée) de cristallisation de la couche de silicium amorphe 10, respectivement analogues aux étapes c1) et c2) décrites ci-dessus.

## Revendications

1. Procédé de synthèse d'un matériau cristallin, comportant les étapes de:
a) réalisation, sur un substrat (2) constitué d'un premier matériau, de germes (6) d'un catalyseur adapté pour solubiliser du carbone,
b) croissance de nanotubes de carbone (8) à partir des germes (6), et
c) réalisation d'une couche d'un deuxième matériau, comportant au moins un domaine monocristallin (12) orienté à partir d'un germe (6).

2. Procédé selon la revendication 1, dans lequel, au cours de l'étape b), on oriente les germes (6) sous champ magnétique.

3. Procédé selon l'une des revendications précédentes, dans lequel le premier matériau est un matériau amorphe.

4. Procédé selon l'une des revendications précédentes, dans lequel le catalyseur comprend un métal de transition.

5. Procédé selon l'une des revendications précédentes, dans lequel le deuxième matériau est du silicium.

6. Procédé selon l'une des revendications précédentes, dans lequel l'étape c) comporte les sous étapes:
. c1) au cours de laquelle on dépose, sur le substrat (2) et des germes (6) situés au sommet de nanotubes de carbone (8), le deuxième matériau (10) sous forme amorphe, puis
. c2) au cours de laquelle on procède à une cristallisation du deuxième matériau en phase solide.

7. Procédé selon l'une des revendications précédentes, dans lequel l'étape a) comporte les sous étapes :
. a1) au cours de laquelle on réalise, sur le substrat, des plots (4) du catalyseur, puis
. a2) au cours de laquelle on recuit le substrat (2) et les plots (4), pour former des germes (6).

8. Procédé selon l'une des revendications 1 à 6, dans lequel l'étape a) comporte les sous étapes :
. a'1) au cours de laquelle on dépose, sur le substrat (2), un film mince constitué du catalyseur, puis
. a'2) au cours de laquelle on recuit le substrat (2) et le film mince, pour former des germes (6).

9. Procédé selon l'une des revendications 1 à 6, dans lequel l'étape a) comporte les sous étapes :
. a"1) au cours de laquelle on implante des ions métalliques dans une couche mince (30),
. a"2) au cours de laquelle on réalise un recuit de la couche mince (30) dans laquelle des ions ont été implantés, afin de former des précipités métalliques (31) à partir des ions implantés,
. a"3) au cours de laquelle on procède à une attaque sélective de la couche mince (30) pour faire apparaître en surface des précipités métalliques, qui formeront des germes (6).

10. Procédé selon l'une des revendications 7 à 9, dans lequel au cours des étapes a2), a'2) ou a"2), un champ magnétique est appliqué pour orienter les germes (6).

11. Procédé selon l'une des revendications 1 à 6, dans lequel l'étape a) comporte les sous étapes:
- a'''1) de dépôt d'une couche de résine (40) de masquage sur la couche mince (30), de réalisation de motifs dans la résine (40), et de gravure de la couche mince (30), au niveau des motifs pour former des puits (41),
- a"'2) de dépôt du catalyseur,
- a"'3) de dissolution de la résine (40), et
- a'''4) de recuit de la couche mince (30) et du catalyseur dans les puits (41), pour former des germes (6).

12. Matériau comportant :
- un substrat (2) constitué d'un premier matériau, s'étendant essentiellement dans un plan,
- des nanotubes de carbone (8) s'étendant longitudinalement essentiellement perpendiculairement au plan du substrat (2), entre une extrémité libre et un extrémité solidaire du substrat (2),
- des germes (6) d'un catalyseur sensiblement situés à proximité de l'extrémité libre des nanotubes de carbone (8) et
- au moins un domaine (12) d'un deuxième matériau cristallisé et orienté à partir d'un moins un germe (6).

## Claims

1. A method of synthesizing.a crystalline material, comprising the steps of:
a) producing seeds (6) of a catalyst adapted to dissolve carbon on a substrate (2) constituted by a first material;
b) growing carbon nanotubes (6) from the seeds (6); and
c) producing a layer of a second material comprising at least one monocrystalline region (12) orientated from a seed (6).

2. A method according to claim 1 in which, during step b), the seeds (6) are orientated in a magnetic field.

3. A method according to one of the preceding claims, in which the first material is an amorphous material.

4. A method according to one of the preceding claims, in which the catalyst comprises a transition metal.

5. A method according to one of the preceding claims, in which the second material is silicon.

6. A method according to one of the preceding claims, in which step c) comprises the following sub-steps:
· c1), during which the second material (10) is deposited in an amorphous form on the substrate (2) and seeds (6) located at the tops of carbon nanotubes (8); then
· c2), during which the second material is crystallized in the solid phase.

7. A method according to one of the preceding claims, in which step a) comprises the following sub-steps:
· a1), during which studs (4) of the catalyst are produced on the substrate; then
· a2), during which the substrate (2) and the studs (4) are annealed to form seeds (6).

8. A method according to one of claims 1 to 6, in which step a) comprises the following sub-steps:
· a'1), during which a thin film constituted by the catalyst is deposited on the substrate (2); then
· a'2), during which the substrate (2) and the thin film are annealed to form seeds (6).

9. A method according to one of claims 1 to 6, in which step a) comprises the following sub-steps:
· a"1), during which metal ions are implanted into a thin layer (30);
· a"2), during which the thin layer (30) into which ions have been implanted is annealed to form metallic precipitates (31) from the implanted ions;
· a"3), during which selective attack of the thin layer (30) is carried out to cause metallic precipitates, which will form seeds (6), to appear on the surface.

10. A method according to one of claims 7 to 9 in which, during steps a2), a'2) or a"2), a magnetic field is applied to orientate the seeds (6).

11. A method according to one of claims 1 to 6, in which step a) comprises the following sub-steps:
· a"'1), of depositing a layer of masking resin (40) on the thin layer (30), of producing patterns in the resin (40), and of etching the thin layer (30) at the patterns to form pits (41);
· a"'2), of depositing the catalyst;
· a"'3), of dissolving resin (40); and
· a"'4), of annealing the thin layer (30) and catalyst in the pits (41) to form seeds (6).

12. A material comprising:
· a substrate (2) constituted by a first material extending essentially in a plane;
· carbon nanotubes (8) extending longitudinally essentially perpendicular to the plane of the substrate (2) between a free end and an end which is fixed to the substrate (2);
· seeds (6) of a catalyst substantially located near the free end of the carbon nanotubes (8); and
· at least one domain (12) of a second crystallized material orientated from at least one seed (6).

## Patentansprüche

1. Verfahren zur Synthese eines kristallinen Materials, umfassend die Schritte:
a) Bilden von Keimen (6) eines Katalysators, der geeignet ist, Kohlenstoff zu solubilisieren, auf einem Substrat (2) aus einem ersten Material,
b) Züchten von Kohlenstoff-Nanoröhren (8) aus den Keimen (6), und
c) Bilden einer Schicht eines zweiten Materials, umfassend mindestens einen monokristallinen Bereich (12), der von einem Keim (6) ausgehend orientiert ist.

2. Verfahren gemäß Anspruch 1, wobei im Verlauf von Schritt b) die Keime (6) im magnetischem Feld orientiert werden.

3. Verfahren gemäß einem der vorhergehenden Ansprüche, wobei das erste Material ein amorphes Material ist.

4. Verfahren gemäß einem der vorhergehenden Ansprüche, wobei der Katalysator ein Übergangsmetall umfasst.

5. Verfahren gemäß einem der vorhergehenden Ansprüche, wobei das zweite Material Silicium ist.

6. Verfahren gemäß einem der vorhergehenden Ansprüche, wobei der Schritt c) die Unterschritte umfasst:
c1) im Verlauf dessen man auf dem Substrat (2) und den Keimen (6), die sich an der Spitze der Kohlenstoff-Nanoröhren (8) befinden, das zweite Material (10) in amorpher Form aufbringt, dann
c2) im Verlauf dessen man die Kristallisation des zweiten Materials in fester Phase vornimmt.

7. Verfahren gemäß einem der vorhergehenden Ansprüche, wobei der Schritt a) die Unterschritte umfasst:
a1) im Verlauf dessen man auf dem Substrat Bereiche (4) des Katalysators bildet, dann
a2) im Verlauf dessen man das Substrat (2) und die Bereiche (4) tempert, um Keime (6) zu bilden.

8. Verfahren gemäß einem der Ansprüche 1 bis 6, wobei der Schritt a) die Unterschritte umfasst:
a'1) im Verlauf dessen man auf dem Substrat (2) einen Dünnfilm, gebildet aus einem Katalysator, aufbringt, dann
a'2) im Verlauf dessen man das Substrat (2) und den Dünnfilm tempert, um Keime (6) zu bilden.

9. Verfahren gemäß einem der Ansprüche 1 bis 6, wobei der Schritt a) die Unterschritte umfasst:
a"1) im Verlauf dessen man Metallionen in eine Dünnschicht (30) implantiert,
a"2) im Verlauf dessen man einen Tempervorgang der Dünnschicht (30) durchführt, in welche Ionen eingebracht wurden, um metallische Ausfällungen (31) ausgehend von den implantierten Ionen zu bilden,
a"3) im Verlauf dessen man ein selektives Ätzen der Dünnschicht (30) durchführt, um metallische Ausfällungen auf der Oberfläche erscheinen zu lassen, die Keime (6) bilden.

10. Verfahren gemäß einem der Ansprüche 7 bis 9, wobei in einem der Schritte a2), a'2) oder a"2) ein magnetisches Feld angelegt wird, um die Keime (6) zu orientieren.

11. Verfahren gemäß einem der Ansprüche 1 bis 6, wobei der Schritt a) die Unterschritte umfasst:
a'"1) Aufbringen einer Harz-Maskenschicht (40) auf die Dünnschicht (30), Bilden von Mustern in dem Harz (40) und Ätzen der Dünnschicht (30) im Bereich der Muster, um Vertiefungen (41) zu bilden,
a"'2) Aufbringen des Katalysators,
a"'3) Lösen des Harzes (40), und
a"'4) Tempern der Dünnschicht (30) und des Katalysators in den Vertiefungen (41), um Keime (6) zu bilden.

12. Material, umfassend:
- ein Substrat (2), bestehend aus einem ersten Material, das sich im Wesentlichen auf einer Ebene erstreckt,
- Kohlenstoff-Nanoröhren (8), die sich in Längsrichtung im Wesentlichen senkrecht zur Ebene des Substrats (2) zwischen einem freien Ende und einem mit dem Substrat (2) verbundenen Ende erstrecken,
- Keime (6) eines Katalysators, die sich deutlich in der Nähe des freien Endes der Kohlenstoff-Nanoröhren (8) befinden, und
- mindestens einen Bereich (12) eines zweiten kristallisierten und von mindestens einem Keim (6) ausgehend orientierten Materials.
